# EUROPEAN PATENT SPECIFICATION

(11) **EP 3 876 421 B1**
(45) Date of publication and mention of the grant of the patent: **18.02.2026**
(21) Application number: 20161394.0
(22) Date of filing: 06.03.2020
(51) Int. Cl.: H03F 3/19, H03F 3/24, H03F 1/02, H03F 1/56

(54) **HIGH FREQUENCY AMPLIFIER AND METHOD FOR AMPLIFYING A HIGH FREQUENCY SIGNAL**
HOCHFREQUENZVERSTÄRKER UND VERFAHREN ZUR VERSTÄRKUNG EINES HOCHFREQUENZSIGNALS
AMPLIFICATEUR À HAUTE FRÉQUENCE ET PROCÉDÉ D'AMPLIFICATION D'UN SIGNAL HAUTE FRÉQUENCE

(43) Date of publication of application: 08.09.2021
(73) Proprietor: Rohde & Schwarz GmbH & Co. KG, 81671 München (DE)
(72) Inventor: LLOYD, Paul, 81827 Munich (DE)
(74) Representative: Novagraaf Group

(56) References cited:
- EP-A1- 2 288 021
- WO-A1-2015/063434
- CN-A- 105 932 969
- GB-A- 2 356 095
- US-A1- 2015 236 729
- US-A1- 2018 123 521

## Description

The present invention relates to a high frequency amplifier and a method for amplifying a high frequency signal. In particular, the present invention relates to a power efficient amplification by a class A amplifier.

### BACKGROUND

Although applicable in principle to any amplifier, the present invention and its underlying problem will be hereinafter described in conjunction with amplification of radio frequency signals.

Wireless communication is based on generation, transmission and reception of radio frequency signals. For this purpose, radio frequency signals have to be generated and amplified in order to establish wireless communication links. Furthermore, modern transmission approaches are based on an amplitude modulated encoding. In this way, high transmission rates can be achieved. However, amplification of amplitude modulated radio frequency signals require appropriate amplifiers. Amplifiers dealing with amplitude modulated signals usually have a relative high power dissipation.

However, high power dissipation goes around with high power consumption and high thermal stress. Furthermore, higher power consumption may reduce the operational time of battery driven wireless communication devices.

Against this background, a problem addressed by the present invention is to provide an improved and power efficient amplification of signals. In particular, the present invention aims to provide a power efficient amplification of radio frequency signals, in particular amplitude modulated signals.

WO 2015/063434 A1 discloses an amplifier circuit comprising an amplifying element configured to amplify a radiofrequency input signal; a bias modulator configured to provide a bias voltage to the amplifying element, the bias voltage depending on a bias control signal; and a tuneable matching network configured to modulate the load to which the output of the amplifying element is applied.

GB 2 356 095 A discloses a transmitter amplifying arrangement for linear modulation schemes, in which the signal in the power amplifier is amplified as a constant envelope signal, so that efficient amplification may be used, e.g. class C. An impedance network following the amplifier is then controlled to produce a desired amplitude modulation. A pre-distortion arrangement is also described.

CN 105 932 969 discloses a power amplifier including a gain control circuit, an input matching network, an amplifier module and an output matching network which are sequentially electrically connected; and a digital signal processing module and a power supply module. A first output end of the digital signal processing module is electrically connected to the power supply module, and a second output end of the digital signal processing module is electrically connected to the gain control circuit.

EP 2 288 021 A1 describes an amplifier for amplification of an RF input signal, comprising: an output stage, a modulator for providing a signal-specific supply voltage to the output stage based on an envelope of the RF input signal, and at least one adaptive output impedance matching unit for adapting an output impedance of the output stage, wherein the amplifier is designed to adapt the at least one adaptive output matching unit based on the signal-specific supply voltage that is provided to the output stage and preferably also on a specific load condition.

US 2015/0236729 A1 describes a communication unit that comprises a radio frequency, RF, transmitter comprising: a power amplifier, PA, module; an envelope tracking system operably coupled to the PA module and arranged to variably control a supply voltage for the PA module; and a load control system operably coupled to an output of the PA module and arranged to control a power amplifier output load. US

2018/0123521 A1 describes an amplifier circuit that comprises an amplifying device configured to amplify a radiofrequency signal, the amplifying device having an output dynamic range; a supply modulator configured to modulate a supply voltage supplied to the amplifying device when an output of the amplifying device is within a first region of the output dynamic range; a tuneable matching network coupled to an output of the amplifying device; and a load controller configured to control the tuneable matching network, when the output of the amplifying device is within a second region of the output dynamic range, and thereby modulate the load to which the output of the amplifying device is applied.

### SUMMARY

The present invention provides a high frequency amplifier and a method for amplifying high frequency signals with the features of the independent claims. Further advantageous embodiments are subject matter of the dependent claims.

According to a first aspect, a high frequency amplifier is provided. The high frequency amplifier comprises an input terminal, a biasing device, an amplifying device, an envelope tracker and a load modulator. The input terminal is configured to receive an input signal, in particular, a high frequency radio frequency signal. The biasing device is configured to bias the input signal. For this purpose, the biasing device may apply a direct current (DC) offset to the received input signal. The amplifying device is configured to amplify the biased input signal. The envelope tracker is configured to track an envelope curve of the input signal. The envelope tracker is further configured to adapt a supply voltage of the amplifying device. In particular, the supply voltage of the amplifying device may be adapted based on the tracked envelope curve of the input signal. The load modulator is configured to adapt a ratio of an output current to an output voltage of the output signal provided by the high frequency amplifier. In particular, the ratio of the output current to the output voltage may be adapted based on the tracked envelope curve of the input signal.

According to a further aspect, a method for amplifying a high frequency signal is provided. The method comprises receiving an input signal, biasing the received input signal and amplifying the biased input signal. In particular, the biased input signal may be amplified by an amplifying device. The method further comprises tracking an envelope curve of the input signal and adapting a supply voltage of the amplifying device. In particular, the supply voltage may be adapted based on the tracked envelope curve of the input signal. Further, the method comprises adapting a ratio of an output current to an output voltage of the amplified signal. The ratio of the output current to the output voltage may be adapted based on the tracked envelope curve of the input signal.

The present invention is based on the finding that amplification of amplitude modulated signals may cause relative high power losses. In particular, amplification of amplitude modulated signals, especially amplitude modulated radio frequency signals, may be performed by so called class A amplifier. However, efficiency of class A amplifiers is very low.

The present invention takes into account this finding and aims to provide an improved and power efficient amplification of signals, in particular of high frequency signals, especially amplitude modulated high frequency signals. For this purpose, the present invention aims to combine two approaches for reducing power dissipation of amplifiers. In particular, the present invention provides a class A power amplification which can achieve power saving by combining the advantages of power supply modulation and load modulation.

Even though it is known that both, power supply modulation and load modulation may improve the efficiency of an amplifier when only applying one of these approaches, a simple straight forward combination of power supply modulation and load modulation may even cause negative effects in view of efficiency. Hence, combining power supply modulation and load modulation in a common amplifier usually is considered to be not appropriate for improving the efficiency of an amplifier.

Despite this knowledge, the present invention suggests applying both, power supply modulation and load modulation in a common amplification approach. Even though a combination of a standard power supply modulation and a standard load modulation might decrease efficiency of an amplifier, the efficiency of an amplifier can be improved by combining power supply modulation with a modified load modulation scheme. In particular, by adapting the standard load modulation approach and combining the modified load modulation with power supply modulation, the efficiency of the amplifier can be further improved.

The amplifier according to the present invention may be used, for example, for amplifying amplitude modulated signals. In particular, the amplifier may operate as a so called class A amplifier. A class A amplifier of an amplifying device may conduct over the entire range of an input cycle. In particular, the amplifier may operate an amplifying element such that the amplifying element remains conducting all over the time.

In order to achieve the above mentioned requirement that the active element is always operated in a conducting state, it may be necessary to bias the input signal. For this purpose, a direct current (DC) offset may be applied to the input signal. Especially, the DC offset may have an appropriate value. For example, a zero crossing of the input signal may be biased such that the zero crossing value is shifted to the middle of an operating range of the amplifier. However, it is understood, that any other appropriate scheme for biasing the input signal may be also possible.

The envelope tracker may monitor the input signal received at the input terminal. For example, an average value over a specific period in time, a root mean square (RMS) value or any other appropriate value for determining an envelope curve of the input signal may be determined. Based on the determined envelope curve of the input signal, a supply voltage of the amplifying device for amplifying the input signal may be adapted. For example, the supply voltage of the amplifying device may be reduced if the envelope curve of the input signal decreases. Accordingly, the supply voltage may be increased, if the envelope curve of the input signal raises. In any case, the supply voltage of the amplifying device is adapted in such a manner that the amplifying device can always perform an appropriate amplification. Furthermore, the supply voltage of the amplifying device may be reduced in such a manner that the power dissipation of the amplifying device can be reduced or even minimized.

The load modulator may be any kind of appropriate device or circuit for adapting the impedance of the amplifier with respect to the load connected at an output board of the amplifier. For example, the load modulator may comprise an adaption network or the like for adapting the output impedance. However, it is understood, that any other device or circuit may be also possible which can adapt a ratio between the output current and the output voltage of the amplifier. In particular, the ratio between output current and output voltage is adapted with respect to the envelope curve of the input signal which may be tracked by the envelope tracker. However, the ratio between output current and output voltage may be also adapted based on other features, in particular properties of the input signal.

Since the general concept of tracking an envelope curve of the input signal and performing a supply voltage modulation based on the envelope curve of the input signal, and performing a load modulation by adapting the ratio between output current and output voltage is well known, no further details will be described here.

However, it should be emphasized that the combination of applying supply voltage modulation by adapting the supply voltage of the amplifier based on the envelope curve of the input signal together with load modulation by adapting the ratio between output current and output voltage is considered to be a new inventive concept. Surprisingly, this combination can significantly improve the efficiency of an amplifier by modifying the load modulation concept of the load modulator. In more detail, when combining supply voltage modulation with a load modulation approach, the control of the load modulation is modified such that the load modulation is opposite to a conventional load modulation approach. Especially, the relationship between the output current and the output voltage is reversed. Details of this inversion of the load modulation will be described in more detail below.

Further embodiments of the present invention are subject of further subclaims and of the following description referring to the drawings.

In a possible embodiment, the amplifying device comprises a class A amplifier.

A class A amplifier remains in a conducting mode over the entire range of an input cycle. In other words, the active elements of a class A amplifier remain conducting all of the time. In this way, the output signal of such a class A amplifier can very precisely follow the signal curve of the input signal.

In a possible embodiment, the amplifying device comprises a single transistor. Alternatively, the amplifying device may comprise a number of transistors which are arranged in parallel.

The transistor of the amplifying device may be any kind of appropriate transistor, for example a bipolar transistor in particular a bipolar transistor with an insulated gate (IGBT) or the like. Furthermore, it may be also possible that the amplifier comprises an amplification stage comprising two or even more transistors, for example in a Darlington configuration.

In a possible embodiment, the biasing device is configured to bias the input signal according to a class A amplification.

As already mentioned above, in a class A amplifier the active elements remain conducting all of the time and over the entire range of the input cycle. Accordingly, the input signal of the amplifier requires a bias (i.e. a DC offset) such that the amplification elements can be operated accordingly. For this purpose, a zero crossing of the input signal has to be shifted such that the active elements of the amplifier still remain conducting in case of the lowest values of the input signal. For this purpose, any appropriate circuity for biasing the input signal may be possible.

In a possible embodiment, the load modulator is configured to decrease an impedance of the high frequency amplifier, if the envelope curve of the input signal increases. Furthermore, the load modulator may increase the impedance of the high frequency amplifier, if the envelope curve of the input signal decreases.

In other words, the ratio between the output current and the output voltage of the high frequency amplifier is controlled inversely with respect to the operation scheme of a conventional load modulator. This inverse load modulation in combination with the supply voltage modulation significantly improves the efficiency of the amplifier. Accordingly, the power dissipation in the amplifier, and consequently the thermal load of the amplifier are reduced.

In a possible embodiment, the load modulator may comprise a filter or a filter network.

The filter or filter network of the load modulator may be configured to filter out unwanted frequencies or frequency components. For example, a bandpass filter may be applied to the output of the load modulator in order to limit the frequency range of the output signal. In this way, harmonic or subharmonic frequencies may be eliminated. Additionally or alternatively, the load modulator may comprise a low pass filter and/or a high pass filter. For example, the low pass filter and/or the high pass filter may be arranged between the signal line conducting the amplified signal and a ground or supply voltage. In this way, unwanted frequency components can be eliminated.

In a possible embodiment, the input signal is an amplitude modulated signal.

As already explained above, amplitude modulated signals require a very precise and accurate amplification of the signal waveform. However, conventional energy saving approaches for amplifying high frequency signals may cause deviations or even distortions of the signal waveform when amplifying an input signal. In contrast to this, the present invention provides an energy efficient approach which allows energy efficient amplification of amplitude modulated signals having high accuracy.

With the present invention it is therefore possible to improve the efficiency of an amplifier, in particular a class A amplifier. Especially, high frequency signals such as amplitude modulated radio frequency signals can be amplified with high efficiency and high accuracy. In particular, by combining a supply voltage modulation and a modified load modulation in the amplifier, the efficiency of the amplifier is improved, and thus, power dissipation is minimized. In order to achieve the significant improvement, a conventional supply voltage modulation is combined with a load modulation, wherein the load modulation is realized with an inverted modulation scheme. While a conventional load modulation increases the impedance of the amplifier with an increasing input signal, the load modulation according to the present invention is performed the other way around. By this inverted approach for load modulation, it is possible to combine the supply voltage modulation and the load modulation in order to optimize the efficiency of the amplifier.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments, which are specified in the schematic figures and drawings, in which:
- Fig. 1:: shows a schematic diagram of an amplifier according to an embodiment;
- Fig. 2:: shows a schematic diagram of an amplifying device according to an embodiment;
- Fig. 3:: shows schematic representations RF signals in an amplifier according to an embodiment; and
- Fig. 4:: shows a flow diagram illustrating a method for amplifying a high frequency signal.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown in scale.

In the drawings, same, functionally equivalent and identical operating elements, features and components are provided with same reference signs in each case, unless stated otherwise.

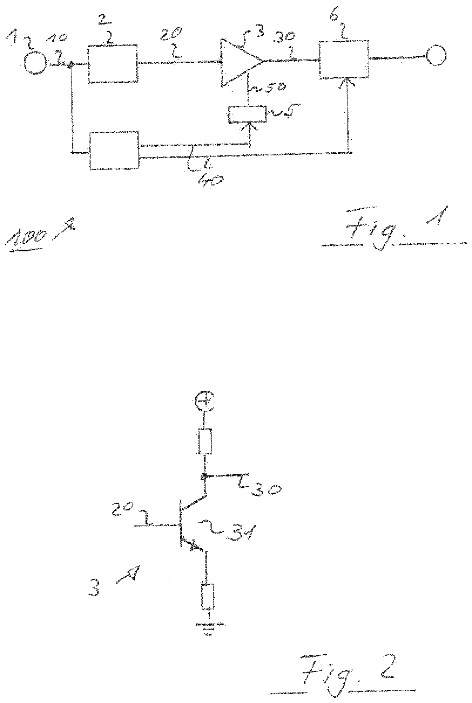

Figure 1 shows a schematic diagram of an amplifier 100 according to an embodiment. The amplifier 100 comprises an input terminal 1 for receiving an input signal 10. Input terminal 1 may comprise any appropriate element for electrically coupling a signal line providing the input signal 10. For example, input terminal 1 may comprise a connector such as a plug or socket for connecting a cable. However, it may be also possible that input terminal 1 may comprise only a soldering point or the like for connecting the amplifier 100 with an appropriate signal source.

The input signal provided at input terminal 1 may be any kind of signal, in particular any kind of high frequency signal. For example, the input signal may be a high frequency signal of a communication system, in particular a wireless communication system. The signal may be, for example, a radio frequency signal which shall be amplified and forwarded to an antenna or antenna system for wireless communication purposes. In a possible example, the signal may be a radio frequency signal of a mobile communication system such as GSM, UMTS, LTE, 5G or the like. Especially, the input signal may be an amplitude modulated signal, in particular an amplitude modulated high frequency signal.

In order to amplify the input signal 10, amplifier 100 comprises an amplifying device 3 which output an amplified signal 30. In particular, amplifying device 3 may an amplifying device according to a class A amplifier. For example, amplifying device 3 may comprise a transistor, in particular a single transistor or arrangement of multiple transistors in a single stage, such as a Darlington configuration.

Since the amplifying element, e.g. the transistor, in a class A amplifier remains conducting over the entire range of the input cycle all of the time, the input signal 10 received at input terminal 1 has to be adapted accordingly. For this purpose, input signal 10 received at the input terminal 1 is provided to a biasing device 2. Biasing device 2 may bias the input signal 10 and output a biased signal 20 to amplifying device 3. For example, biasing device 2 may add a direct current (DC) offset to the input signal 10 in order to shift the zero level of the input signal 10 in the middle of the operating range of amplifying device 3. However, it is understood, that any other appropriate scheme for biasing input signal 10 may be also possible.

Amplifier 100 further comprises an envelope tracker 4 for monitoring the input signal 10. In particular, envelope tracker 4 analyzes input signal 10 to track an envelope curve of input signal 10. For example, envelope tracker 4 may monitor input signal 10 and determine an average value over a specific period in time or a root mean square value (RMS). However, any other manner for determining an envelope curve of the input signal 10 provided at input terminal 1 may be determined.

The determined envelope curve 40 of input signal 10 may be used as a basis for adapting a supply voltage 50 of amplifying device 3. For example, a power supply device 5 may be provided with the envelope curve 40 of input signal 10, and power supply device 5 may adapt the supply voltage of amplifier 3 according to the respective envelope curve 40. In particular, supply voltage 50 of amplifier 3 may be increased if the value of the envelope curve 40 increases, and the value of the supply power for amplifying device 3 may be reduced if the envelope curve 40 of input signal 10 decreases. In this way, by dynamically adapting the supply voltage 50 of amplifying device 3, the power dissipation in amplifying device 3 can be reduced, and thus, the efficiency of the amplification is improved.

Further, amplifier 100 may comprise a load modulator 6 for adapting an impedance of amplifier 100. For this purpose, load modulator 6 may comprise any kind of appropriate device or circuit for dynamically adapting the impedance. In particular, the impedance of amplifier 100 may be adapted in response to the envelope curve 40 of the input signal 10. By adapting the impedance of amplifier 100, the ratio between the output current of amplifier 100 and the output voltage of amplifier 100 is controlled. In particular, load modulator 6 may decrease the impedance of amplifier 100, if the envelope curve 40 of the input signal 10 decreases. Accordingly, load modulator 6 may increase the impedance of the amplifier 100, if the envelope curve of the input signal 10 decreases.

It should be emphasized that this approach of adapting the impedance, and accordingly the ratio between output voltage and output current, is contrary to the conventional scheme of operating a load modulator in a class A amplifier. However, this contradictive operation scheme of load modulator 6 allows a simultaneous combination of supply voltage modulation by adapting the supply voltage of amplifier 3 based on the tracked signal curve together with a load modulation for adapting the ratio between output current and output voltage in response to the tracked signal curve 40 of input signal 10. In this way, the benefits of supply voltage modulation and load modulation can be combined and thus, the efficiency of the amplifier 100 can be further improved. Accordingly, power dissipation in the amplifier 100 is further reduced, which leads to reduced power consumption and less thermal stress.

Load modulator 6 may further comprise a filter or filter network for filtering the amplified signal. For example, a bandpass filter may be used for limiting the frequency range of the output signal. Accordingly, harmonics or subharmonics of the amplified signal can be eliminated. Furthermore, a high pass filter may be arranged between the signal line of the output signal and the ground or the supply voltage. In this way, high frequency disturbances can be eliminated. Furthermore, a low pass filter may be arranged between ground or supply voltage in order to reduce low frequency components or even a DC offset.

Figure 2 shows a schematic diagram of an amplifying device 3 according to an embodiment. As can be seen in this schematic illustration, amplifier 3 may comprise a single transistor 31, for example a bipolar transistor, in particular a bipolar transistor with an insulated gate. However, it is understood, that any other kind of appropriate transistor or amplifying element may be possible, too. Furthermore, amplifier 3 may comprise a circuit with two or more transistors, for example two transistors in a Darlington configuration.

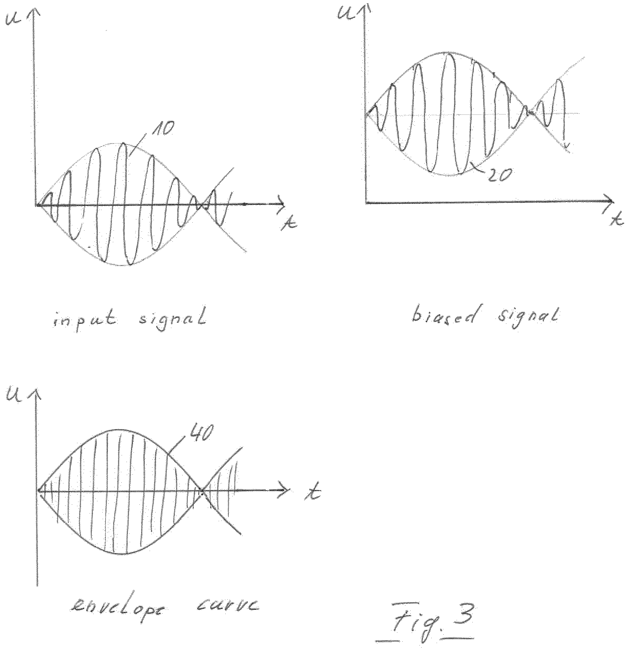

Figure 3 shows a schematic representation of high frequency signals in amplifier 100 according to an embodiment. As can be seen in the first diagram, an input signal 10 may be provided at input terminal 1, which may be a signal having positive and negative values. This signal 10 may be biased. Accordingly, by adding an appropriate DC offset, biased signal 20 may comprise only positive values which may be used as an input signal of a class A amplifier.

Furthermore, envelope tracker 4 may monitor the input signal 10 and output a signal corresponding to an envelope curve 40 of the input signal 10. As already mentioned above, the envelope curve 40 may be used for controlling the power supply of amplifier 3 and controlling load modulator 6.

Accordingly, load modulator 6 controls the ratio between the output current and the output voltage of the output signal provided by amplifier 100.

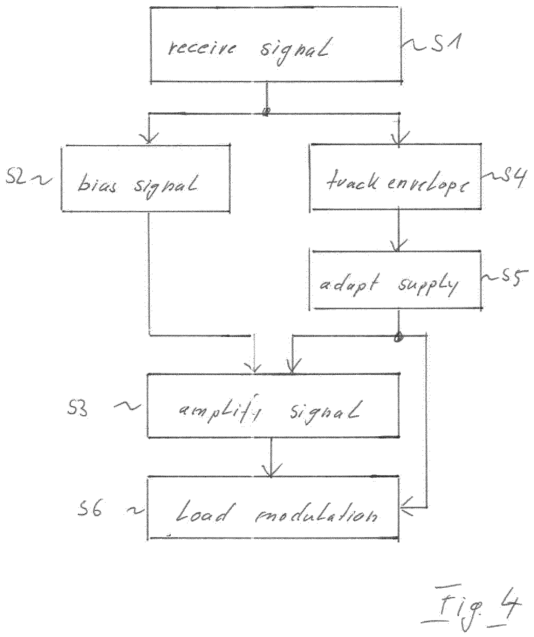

Figure 4 shows a flow diagram illustrating a method for amplifying a high frequency signal according to an embodiment. The method illustrated in figure 4 may perform any operational step as already mentioned above in connection with amplifier 100. Accordingly, amplifier 100 may comprise any kind of element or device for performing operation as described below in connection with the method for amplifying a signal.

In a first step S1, an input signal 10 may be received. For example, the input signal 10 may be received by an input terminal 1.

In step S2, the received input signal 10 is biased. For example, the signal may be biased by biasing device 2.

In step S3, the biased input signal 20 is amplified. For example, the signal may be amplified by an amplifying device 3.

In step S4, an envelope curve 40 of the input signal is tracked. The tracking of the envelope curve 40 may be performed, for example by an envelope tracker 4.

In step S5, a supply voltage of the amplifying device 3 is adapted. In particular, the supply voltage of amplifying device 3 may be adapted based on the tracked envelope curve 40 of the input signal 10.

Furthermore, the ratio of an output current and an output voltage of the amplified signal is adapted in step S6. The adaption of the ratio between output current and output voltage may be based on the tracked envelope curve 40 of the input signal 10.

As already mentioned above, the adaption of the ratio between output current and output voltage is different from the adaption performed by a conventional load modulator. In particular, the impedance of the amplifier 100 is decreased, if the envelope curve of the input signal increases. Accordingly, the impedance of the amplifier 100 is increased, if the envelope curve of the input signal 10 decreases. Due to this specific scheme of adapting the ratio between output current and output voltage, it is possible to combine a supply voltage modulation and a load modulation in an amplifier performing a class A amplification.

Summarizing, the present invention provides an improved amplification of a signal, in particular an amplitude modulated high frequency signal. For this purpose, a supply voltage modulation is combined with load modulation to improve the efficiency of the amplifier. In particular, the load modulation in this combined approach is performed inverted compared to standard load modulation. In particular, the approach of combining power supply modulation and load modulation is performed by a class A amplifier.

### LIST OF REFERENCE SIGNS

- 1: input terminal
- 2: biasing device
- 3: amplifying device
- 31: transistor
- 4: envelope tracker
- 5: power supply device
- 6: load modulator

- 10: input signal
- 20: biased signal
- 30: amplified signal
- 40: envelope curve
- 50: supply voltage

- 100: amplifying device

## Claims

1. High frequency amplifier (100), comprising:
an input terminal (1) configured to receive an input signal (10);
a biasing device (2) configured to bias the input signal (10);
an amplifying device (3) configured to amplify the biased input signal (20);
an envelope tracker (4) configured to track an envelope curve (40) of the input signal (10) and to adapt a supply voltage (50) of the amplifying device (3) based on the envelope curve (40) of the input signal (10); and
a load modulator (6) configured to adapt a ratio of an output current to an output voltage of the high frequency amplifier (100) based on the envelope curve (40) of the input signal (10),
wherein the load modulator (6) is configured to decrease an impedance of the high frequency amplifier (100), if the envelope curve (40) of the input signal (10) increases, and to increase the impedance of the high frequency amplifier (100), if the envelope curve (40) of the input signal (10) decreases;
wherein the high frequency amplifier (100) is configured to adapt the supply voltage and the ratio of the output current to the output voltage together while the amplifying device (3) is in a conducting mode.

2. High frequency amplifier (100) according to claim 1, wherein the amplifying device (3) comprises a class A amplifier.

3. High frequency amplifier (100) according to claim 1 or 2, wherein the amplifying device (3) comprises a single transistor (31), or a number of two or more transistors in a single amplification stage.

4. High frequency amplifier (100) according to any of claims 1 to 3, wherein the biasing device (2) configured to bias the input signal (10) according to a class A amplification.

5. High frequency amplifier (100) according to any of claims 1 to 4, wherein the load modulator (6) comprises a filter or a filter network.

6. High frequency amplifier (100) according to any of claims 1 to 5, wherein the input signal (10) is an amplitude modulated signal.

7. Method for amplifying a high frequency signal, the method comprising:
receiving (S1) an input signal (10);
biasing (S2) the received input signal (10);
amplifying (S3) the biased input signal (20) by an amplifying device (3);
tracking (S4) an envelope curve (40) of the input signal (10);
adapting (S5) a supply voltage (50) of the amplifying device (3) based on the tracked envelope curve (40) of the input signal (10); and
adapting (S6) a ratio of an output current to an output voltage of the amplified signal based on the tracked envelope curve (40) of the input signal (10),
wherein adapting (S6) the ratio of the output current to the output comprises decreasing an impedance of a high frequency amplifier (100), if the envelope curve (40) of the input signal (10) increases, and increasing the impedance of the high frequency amplifier (100), if the envelope curve (40) of the input signal (10) decreases;
wherein the supply voltage and the ratio of the output current to the output voltage are adapted together while the amplifying device (3) is in a conducting mode.

8. Method according to claim 7, wherein the biased input signal (20) is amplified by a class A amplifier.

9. Method according to claim 7 or 8, wherein the biased input signal (20) is amplified by a single transistor (31) or a number of transistors arranged in parallel.

10. Method according to any of claims 7 to 9, wherein the input signal (10) is biased according to a class A amplification.

11. Method according to any of claims 7 to 10, wherein the input signal (10) is an amplitude modulated signal.

12. Method according to any of claims 7 to 11, comprising filtering the amplified signal by a filter of filter network.

## Patentansprüche

1. Hochfrequenzverstärker (100), umfassend:
einen Eingangsanschluss (1), der konfiguriert ist, um ein Eingangssignal (10) zu empfangen;
eine Vorspannungsvorrichtung (2), die konfiguriert ist, um das Eingangssignal (10) vorzuspannen;
eine Verstärkungsvorrichtung (3), die konfiguriert ist, um das vorgespannte Eingangssignal (20) zu verstärken;
einen Hüllkurvenverfolger (4), der konfiguriert ist, um eine Hüllkurve (40) des Eingangssignals (10) zu verfolgen und eine Versorgungsspannung (50) der Verstärkungsvorrichtung (3) basierend auf der Hüllkurve (40) des Eingangssignals (10) anzupassen; und
einen Lastmodulator (6), der konfiguriert ist, um ein Verhältnis eines Ausgangsstroms zu einer Ausgangsspannung des Hochfrequenzverstärkers (100) basierend auf der Hüllkurve (40) des Eingangssignals (10) anzupassen,
wobei der Lastmodulator (6) konfiguriert ist, um eine Impedanz des Hochfrequenzverstärkers (100) zu verringern, wenn die Hüllkurve (40) des Eingangssignals (10) ansteigt, und die Impedanz des Hochfrequenzverstärkers (100) zu erhöhen, wenn die Hüllkurve (40) des Eingangssignals (10) abnimmt;
wobei der Hochfrequenzverstärker (100) konfiguriert ist, um die Versorgungsspannung und das Verhältnis des Ausgangsstroms zur Ausgangsspannung zusammen anzupassen, während sich die Verstärkungsvorrichtung (3) in einem leitfähigen Modus befindet.

2. Hochfrequenzverstärker (100) nach Anspruch 1, wobei die Verstärkungsvorrichtung (3) einen Klasse-A-Verstärker umfasst.

3. Hochfrequenzverstärker (100) nach Anspruch 1 oder 2, wobei die Verstärkungsvorrichtung (3) einen einzelnen Transistor (31) oder eine Anzahl von zwei oder mehr Transistoren in einer einzelnen Verstärkungsstufe umfasst.

4. Hochfrequenzverstärker (100) nach einem der Ansprüche 1 bis 3, wobei die Vorspannungsvorrichtung (2) konfiguriert ist, um das Eingangssignal (10) gemäß einer Klasse-A-Verstärkung vorzuspannen.

5. Hochfrequenzverstärker (100) nach einem der Ansprüche 1 bis 4, wobei der Lastmodulator (6) ein Filter oder ein Filternetzwerk umfasst.

6. Hochfrequenzverstärker (100) nach einem der Ansprüche 1 bis 5, wobei das Eingangssignal (10) ein amplitudenmoduliertes Signal ist.

7. Verfahren zur Verstärkung eines Hochfrequenzsignals, wobei das Verfahren umfasst:
Empfangen (S1) eines Eingangssignals (10);
Vorspannen (S2) des empfangenen Eingangssignals (10);
Verstärken (S3) des vorgespannten Eingangssignals (20) durch eine Verstärkungsvorrichtung (3);
Verfolgen (S4) einer Hüllkurve (40) des Eingangssignals (10);
Anpassen (S5) einer Versorgungsspannung (50) der Verstärkungsvorrichtung (3) basierend auf der verfolgten Hüllkurve (40) des Eingangssignals (10); und
Anpassen (S6) eines Verhältnisses eines Ausgangsstroms zu einer Ausgangsspannung des verstärkten Signals basierend auf der verfolgten Hüllkurve (40) des Eingangssignals (10),
wobei das Anpassen (S6) des Verhältnisses des Ausgangsstroms zum Ausgang das Verringern einer Impedanz eines Hochfrequenzverstärkers (100) umfasst, wenn die Hüllkurve (40) des Eingangssignals (10) ansteigt, und das Erhöhen der Impedanz des Hochfrequenzverstärkers (100), wenn die Hüllkurve (40) des Eingangssignals (10) abnimmt;
wobei die Versorgungsspannung und das Verhältnis des Ausgangsstroms zur Ausgangsspannung zusammen angepasst werden, während sich die Verstärkungsvorrichtung (3) in einem leitfähigen Modus befindet.

8. Verfahren nach Anspruch 7, wobei das vorgespannte Eingangssignal (20) durch einen Klasse-A-Verstärker verstärkt wird.

9. Verfahren nach Anspruch 7 oder 8, wobei das vorgespannte Eingangssignal (20) durch einen einzelnen Transistor (31) oder eine Anzahl von parallel angeordneten Transistoren verstärkt wird.

10. Verfahren nach einem der Ansprüche 7 bis 9, wobei das Eingangssignal (10) gemäß einer Klasse-A-Verstärkung vorgespannt ist.

11. Verfahren nach einem der Ansprüche 7 bis 10, wobei das Eingangssignal (10) ein amplitudenmoduliertes Signal ist.

12. Verfahren nach einem der Ansprüche 7 bis 11, umfassend das Filtern des verstärkten Signals durch einen Filter eines Filternetzwerks.

## Revendications

1. Amplificateur haute fréquence (100), comprenant :
une borne d'entrée (1) configurée pour recevoir un signal d'entrée (10) ;
un dispositif de polarisation (2) configuré pour polariser le signal d'entrée (10) ;
un dispositif d'amplification (3) configuré pour amplifier le signal d'entrée polarisé (20) ;
un suiveur d'enveloppe (4) configuré pour suivre une courbe d'enveloppe (40) du signal d'entrée (10) et pour adapter une tension d'alimentation (50) du dispositif d'amplification (3) sur la base de la courbe d'enveloppe (40) du signal d'entrée (10) ; et
un modulateur de charge (6) configuré pour adapter un rapport d'un courant de sortie à une tension de sortie de l'amplificateur haute fréquence (100) sur la base de la courbe d'enveloppe (40) du signal d'entrée (10),
dans lequel le modulateur de charge (6) est configuré pour diminuer une impédance de l'amplificateur haute fréquence (100), si la courbe d'enveloppe (40) du signal d'entrée (10) augmente, et pour augmenter l'impédance de l'amplificateur haute fréquence (100), si la courbe d'enveloppe (40) du signal d'entrée (10) diminue ;
dans lequel l'amplificateur haute fréquence (100) est configuré pour adapter conjointement la tension d'alimentation et le rapport du courant de sortie à la tension de sortie lorsque le dispositif d'amplification (3) est en mode conducteur.

2. Amplificateur haute fréquence (100) selon la revendication 1, dans lequel le dispositif d'amplification (3) comprend un amplificateur de classe A.

3. Amplificateur haute fréquence (100) selon la revendication 1 ou 2, dans lequel le dispositif d'amplification (3) comprend un transistor unique (31), ou un nombre de deux transistors ou plus dans un étage d'amplification unique.

4. Amplificateur haute fréquence (100) selon l'une quelconque des revendications 1 à 3, dans lequel le dispositif de polarisation (2) est configuré pour polariser le signal d'entrée (10) selon une amplification de classe A.

5. Amplificateur haute fréquence (100) selon l'une quelconque des revendications 1 à 4, dans lequel le modulateur de charge (6) comprend un filtre ou un réseau de filtres.

6. Amplificateur haute fréquence (100) selon l'une quelconque des revendications 1 à 5, dans lequel le signal d'entrée (10) est un signal modulé en amplitude.

7. Procédé permettant d'amplifier un signal haute fréquence, le procédé comprenant :
la réception (S1) d'un signal d'entrée (10) ;
la polarisation (S2) du signal d'entrée reçu (10) ;
l'amplification (S3) du signal d'entrée polarisé (20) par un dispositif d'amplification (3) ;
le suivi (S4) d'une courbe d'enveloppe (40) du signal d'entrée (10) ;
l'adaptation (S5) d'une tension d'alimentation (50) du dispositif d'amplification (3) sur la base de la courbe d'enveloppe suivie (40) du signal d'entrée (10) ; et
l'adaptation (S6) d'un rapport d'un courant de sortie à une tension de sortie du signal amplifié sur la base de la courbe d'enveloppe suivie (40) du signal d'entrée (10),
dans lequel l'adaptation (S6) du rapport du courant de sortie à la sortie comprend la diminution d'une impédance d'un amplificateur haute fréquence (100), si la courbe d'enveloppe (40) du signal d'entrée (10) augmente, et l'augmentation de l'impédance de l'amplificateur haute fréquence (100), si la courbe d'enveloppe (40) du signal d'entrée (10) diminue ;
dans lequel la tension d'alimentation et le rapport du courant de sortie à la tension de sortie sont adaptés conjointement lorsque le dispositif d'amplification (3) est en mode conducteur.

8. Procédé selon la revendication 7, dans lequel le signal d'entrée polarisé (20) est amplifié par un amplificateur de classe A.

9. Procédé selon la revendication 7 ou 8, dans lequel le signal d'entrée polarisé (20) est amplifié par un transistor unique (31) ou par un nombre de transistors agencés en parallèle.

10. Procédé selon l'une quelconque des revendications 7 à 9, dans lequel le signal d'entrée (10) est polarisé selon une amplification de classe A.

11. Procédé selon l'une quelconque des revendications 7 à 10, dans lequel le signal d'entrée (10) est un signal modulé en amplitude.

12. Procédé selon l'une quelconque des revendications 7 à 11, comprenant le filtrage du signal amplifié par un filtre de réseau de filtres.
